Europäisches Patentamt

European Patent Office

Office européen des brevets

(19)

(11) Veröffentlichungsnummer: **0 290 825 B1**

(12) # EUROPÄISCHE PATENTSCHRIFT

(45) Veröffentlichungstag der Patentschrift: **30.12.92**

(51) Int. Cl.⁵: **H03J 3/32**, H03J 7/06

(21) Anmeldenummer: **88106289.7**

(22) Anmeldetag: **20.04.88**

(54) **Videorecorder mit dynamisch abgleichbarem Tuner.**

(30) Priorität: **15.05.87 DE 3716333**

(43) Veröffentlichungstag der Anmeldung:
**17.11.88 Patentblatt 88/46**

(45) Bekanntmachung des Hinweises auf die
Patenterteilung:
**30.12.92 Patentblatt 92/53**

(84) Benannte Vertragsstaaten:
**AT DE FR GB IT**

(56) Entgegenhaltungen:
**EP-A- 0 116 350**
**DE-A- 3 332 206**
**US-A- 4 334 323**
**US-A- 4 500 920**

(73) Patentinhaber: **GRUNDIG E.M.V. Elektro-
Mechanische Versuchsanstalt Max Grundig
holländ. Stiftung & Co. KG.
Kurgartenstrasse 37
W-8510 Fürth/Bay.(DE)**

(72) Erfinder: **Schülein, Reinhard, Dipl.-Ing. (FH)
GRUNDIG E.M.V.
Max Grundig holländ. Stiftung & Co KG
Kurgartenstrasse 37 D-8510 Fürth/Bay(DE)**

## Beschreibung

Die Erfindung betrifft einen Videorecorder der im Oberbegriff des Patentanspruchs angegebenen Art.

Videorecorder mit dynamisch abgleichbaren Tunern sind bekannt. Der dynamische Abgleich eines Tuners selbst ist Gegenstand der DE-C-33 03 711. Dort werden bei der Anwahl eines Empfangskanals die HF-Filterkreise mit einer der Empfangsfrequenz entsprechenden Referenzfrequenz, die an den Antenneneingang des Tuners geschaltet ist, erregt. Eine dem Ausgang der HF-Filterkreise entnehmbare Meßspannung wird einem Rechner zugeführt, der schrittweise die Abstimmwerte für die einzelnen Filterkreise verändert, bis ein Maximalwert der Meßspannung erreicht ist. Die während des Abgleichs ermittelten Abstimmwerte werden in geeigneten Zwischenspeichern abgelegt.

Die Erzeugung der Referenzfrequenz kann, wie zum Beispiel in der DE-A-33 32 206, die gleichfalls ein Verfahren bzw. eine Anordnung zum dynamischen Abgleich eines Tuners betrifft, beschrieben, über einen PLL-gesteuerten Signalgenerator, insbesondere einen hierin enthaltenen, mit einem Mikroprozessor gekoppelten spannungsgesteuerten Oszillator erfolgen.

Derartige Einrichtungen erfordern jedoch einen hohen technischen und kostenmäßigen Aufwand, der sich insbesondere bei ohnehin aufwendigen Geräten wie Videorecordern nachteilig auswirkt.

Der Erfindung liegt die Aufgabe zugrunde, einen Videorecorder der im Oberbegriff des Patentanspruchs angegebenen Art so auszubilden, daß der technische Aufwand für den dynamischen Tunerabgleich vermindert wird.

Diese Aufgabe wird gemäß der Erfindung durch die im Patentanspruch angegebenen Merkmale gelöst.

Der Videorecorder gemäß der Erfindung zeichnet sich dadurch aus, daß ein ohnehin vorhandener Signalgenerator, nämlich der spannungsgesteuerte Oszillator des HF-Modulators, auch als Referenzoszillator für den dynamischen Abgleich des Tuners dient. Hierdurch kann in vorteilhafter Weise ein vollständiger spannungsgesteuerter Oszillator eingespart werden.

Ein Schaltungsbeispiel für einen Videorecorder gemäß der Erfindung ist im folgenden anhand einer Zeichnung näher erläutert. Die dargestellte Blockschaltung beschränkt sich hierbei auf die für den dynamischen Tunerabgleich relevanten Schaltungsteile des Recorders.

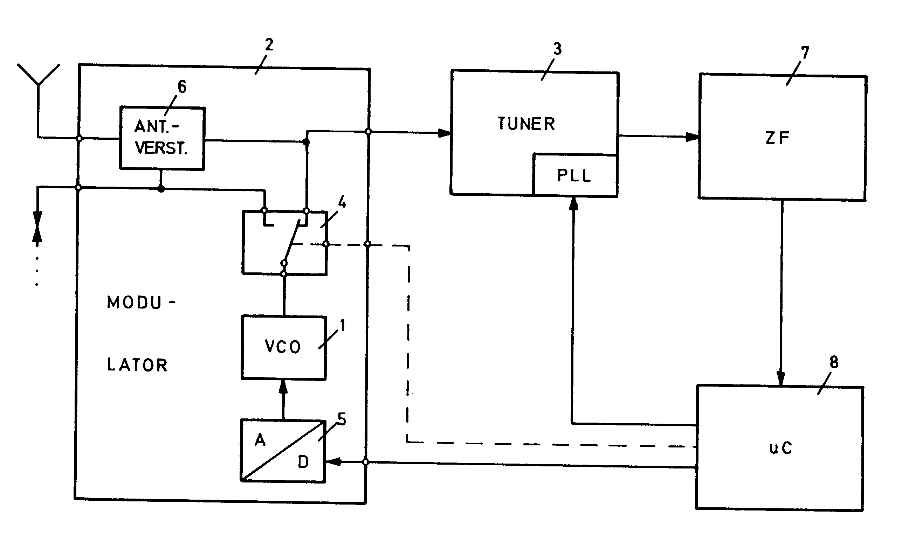

Die Figur zeigt einen HF-Modulator 2, der gemäß der Erfindung neben einem spannungsgesteuerten Oszillator 1, einem den Oszillator ansteuernden D/A-Wandler 5 und einem Antennenverstärker 6 noch eine über einen Mikrocomputer 8 steuerbare Umschalteinrichtung 4 enthält. Über die Umschalteinrichtung 4 ist es möglich, das Ausgangssignal des spannungsgesteuerten Oszillators 1 wahlweise dem Modulator 2 selbst oder aber dem Eingang eines Tuners 3 zum dynamischen Abgleich desselben zuzuführen. Am Ausgang des Tuners 3 wird über einen ZF-Verstärker 7 ein Meß- bzw. Regelsignal gewonnen, das über den Mikrocomputer 8 ausgewertet und in an sich bekannter Weise zum Abgleich des Tuners bzw. zur Abstimmung des spannungsgesteuerten Oszillators verwendet wird.

## Patentansprüche

1. Videorecorder, enthaltend
   - einen über einen Referenzoszillator dynamisch abgleichbaren Tuner (3),
   - einen über einen spannungsgesteuerten Oszillator (1) abstimmbaren HF-Modulator (2),
   - sowie einen den Abgleich des Tuners und die Abstimmung des HF-Modulators steuernden Mikrocomputer (8),

   **dadurch gekennzeichnet,** daß zwischen den spannungsgesteuerten Oszillator (1) des HF-Modulators (2), den HF-Modulator (2) selbst und den Tuner (3) eine über den Mikrocomputer (8) steuerbare Umschalteinrichtung (4) geschaltet ist, die zum dynamischen Abgleich des Tuners (3) den spannungsgesteuerten Oszillator (1) vom HF-Modulator (2) trennt und den spannungsgesteuerten Oszillator (1) als Referenzoszillator mit dem Eingang des Tuners verbindet.

## Claims

1. Video recorder, containing
   - a tuner (3) which can be dynamically calibrated via a reference oscillator,
   - an RF modulator (2) which can be tuned via a voltage-controlled oscillator (1),
   - and a microcomputer (8) which controls the calibration of the tuner and the tuning of the RF modulator,

   characterised in that, between the voltage-controlled oscillator (1) of the RF modulator (2), the RF modulator (2) itself and the tuner (3), a switch-over device (4) is connected which can be controlled via the microcomputer (8) and which, for the dynamic calibration of the tuner (3), disconnects the voltage-controlled oscillator (1) from the RF modulator (2) and connects the voltage-controlled oscillator (1) as the reference oscillator to the input of the tuner.

## Revendications

**1.** Enregistreur vidéo, comportant

- un syntoniseur (3) réglable de façon dynamique par l'intermédiaire d'un oscillateur de référence,
- un modulateur HF (2) accordable par l'intermédiaire d'un oscillateur (1) commandé par la tension,
- ainsi qu'un micro-ordinateur (8) qui commande le réglage du syntoniseur et l'accord du modulateur HF,

caractérisé en ce qu'entre l'oscillateur (1), commandé par la tension, du modulateur HF (2), le modulateur HF (2) luimême et le syntoniseur (3) est branché un dispositif de commutation (4) qui peut être commandé par l'intermédiaire du micro-ordinateur (8) et qui, pour réaliser le réglage dynamique du syntoniseur (3), déconnecte l'oscillateur (1), commandé par la tension, par rapport au modulateur HF (2) et relie l'oscillateur (1), commandé par la tension, en tant qu'oscillateur de référence à l'entrée du syntoniseur.